# EUROPÄISCHE PATENTSCHRIFT

(11) **EP 0 829 136 B1**
(45) Veröffentlichungstag und Bekanntmachung des Hinweises auf die Patenterteilung: **05.07.2000**
(21) Anmeldenummer: 96910900.8
(22) Anmeldetag: 20.04.1996
(51) Int. Cl.: H03K 17/0812

(54) **Integrierte Schaltung mit thermischer Abregelung**
Integrated circuit with thermal control
Circuit intégré avec régulation thermique

(30) Priorität: 27.05.1995 DE 19519477
(43) Veröffentlichungstag der Anmeldung: 18.03.1998
(73) Patentinhaber: ROBERT BOSCH GMBH, 70442 Stuttgart (DE)
(72) Erfinder: MICHEL, Hartmut, D-72762 Reutlingen (DE); PLUNTKE, Christian, D-72379 Hechingen (DE)
(74) Vertreter: Friedmann, Jürgen, Dr.-Ing.
(86) Internationale Anmeldenummer: DE9600689
(87) Internationale Veröffentlichungsnummer: WO9637955

(56) Entgegenhaltungen:
- DE-A- 3 003 722
- GB-A- 2 234 112
- US-A- 3 889 137

## Beschreibung

Die Erfindung betrifft eine integrierte Schaltung mit einem Leistungstransistor und mit einer eine Verlustleistung des Leistungstransistors temperaturabhängig abregelnden Schaltungsanordnung.

### Stand der Technik

Es ist bekannt, Halbleiterbauelemente, insbesondere Leistungstransistoren, so zu dimensionieren, daß deren aktivierbare Leistung die üblicherweise zulässigen Dauerbeanspruchungen und damit auftretenden Dauerverluste bei weitem übersteigt. Somit können die Halbleiterbauelemente kostengünstiger gefertigt werden, da diese nicht für den Dauerbetrieb mit der aktivierbaren Leistung ausgelegt zu werden brauchen. Es ist bekannt, den Halbleiterbauelementen Schutzschaltungen zuzuordnen, die in Abhängigkeit einer Bauelementetemperatur des Bauelementes aktivierbar sind, so daß eine Zerstörung der Bauelemente aufgrund einer langanhaltenden Dauerbelastung - für die diese nicht ausgelegt sind - verhindert werden kann.

Hierzu sind Schaltungsanordnungen bekannt, bei denen das Halbleiterbauelement bei Überschreiten einer Grenztemperatur abgeschaltet wird. Die Abschaltung des Leistungstransistors erfolgt hierbei mittels einer Flußspannungs- beziehungsweise Sperrstrommessung an integrierten Sensorelementen, die eine entsprechende Ansteuerung des Halbleiterbauelementes bewirken. Hierzu wird auf Tietze und Schenk, 9. Auflage, Seite 523, verwiesen.

Aus der DD-PS 227 835 ist eine integrierte Übertemperatur-Schutzschaltungsanordnung bekannt, bei der bipolare Transistoren derart zusammengeschaltet sind, daß eine Basis-Emitterspannung eines Transistors mit einer Hysterese beaufschlagt wird, wobei im eingeschalteten Zustand des Transistors ein Arbeitsstrom durch den Einsatz eines Stromspiegels so verändert wird, daß ein Strom abgeführt wird, der kleiner ist als der Arbeitsstrom und zu diesem immer in einem konstanten Verhältnis steht. Hierbei erfolgt ein temperaturabhängiges Ein- beziehungsweise Ausschalten des Leistungstransistors. Ein Abregeln der Verlustleistung ohne Abschalten ist nicht möglich. Weiterhin ist nachteilig, daß diese Schaltung nur in Temperaturbereichen bis ca. 150 °C einsetzbar ist.

Aus der GB-A 2 234 112 ist ein Halbleiterschalter mit Übertemperaturschutz bekannt, der ein temperatursensitives Element aufweist. Das temperatursensitive Element ist in Form einer in Sperrichtung geschalteten Diode ausgebildet und veranlaßt eine Ableitung des Treiberstroms des Halbleiterschalters, falls dieser zu heiß wird.

### Vorteile der Erfindung

Die erfindungsgemäße integrierte Schaltung mit den im Anspruch 1 genannten Merkmalen bietet demgegenüber den Vorteil, daß auch für sehr hohe Temperaturen, die beispielsweise bei ca. 200 °C liegen können, eine temperaturabhängige Abregelung der Verlustleistung eines Leistungstransistors erfolgen kann. Dadurch, daß ein Transistor vorgesehen ist, dessen sich temperaturabhängig ändernder Sperrstrom eine Änderung des Basisstroms des Leistungstransistors auslöst, ist es vorteilhaft möglich, eine toleranzstabile Regelung des Leistungstransistors bei sehr hohen Temperaturen durchzuführen. Durch die temperaturabhängige Regelung des Basisstroms des Leistungstransistors kann die gesamte Schaltungsanordnung sehr einfach und damit kostengünstig aufgebaut werden. Insbesondere ist vorteilhaft, daß durch die Verwendung des Sperrstromes zur Auslösung einer Regelung des Leistungstransistors eine kontrollierte Abregelung des Basisstromes und damit des Leistungstransistors möglich ist.

Vorteilhafte Ausgestaltungen der Erfindung ergeben sich aus den in den abhängigen Ansprüchen genannten Merkmalen.

### Zeichnung

Die Erfindung wird nachfolgend in Ausführungsbeispielen anhand der zugehörigen Zeichnungen näher erläutert. Es zeigen:
- Figur 1: eine Schaltungsanordnung einer erfindungsgemäßen integrierten Schaltung;
- Figur 2: in einem Diagramm der. temperaturabhängigen Verlauf eines Sperrstromes;
- Figur 3: eine erfindungsgemäße Schaltungsanordnung in einer weiteren Ausführungsvariante und
- Figur 4a und 4b: in Diagrammen den temperaturabhängigen Verlauf des Regelstroms der Schaltungsanordnungen.

### Beschreibung der Ausführungsbeispiele

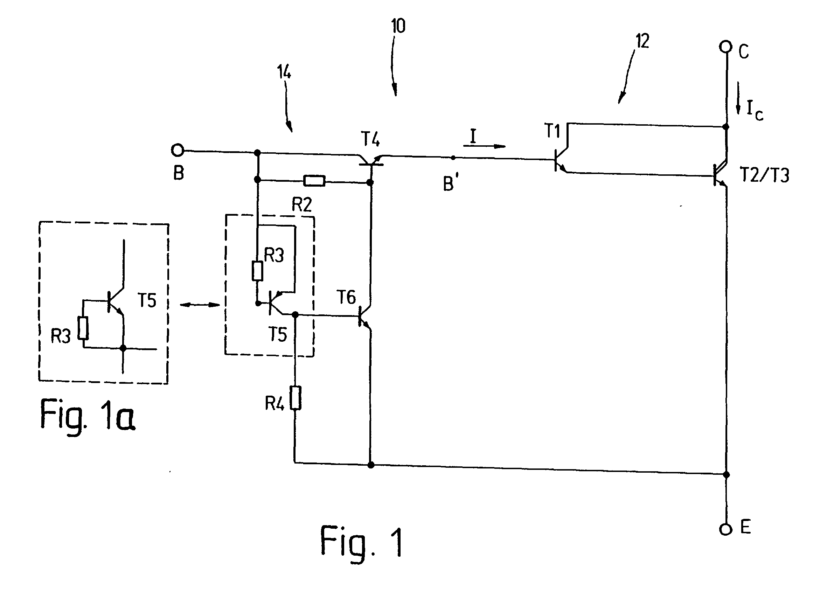

Figur 1 zeigt eine insgesamt mit 10 bezeichnete integrierte Schaltung. Die integrierte Schaltung 10 weist einen Leistungstransistor 12 und eine Schaltungsanordnung 14 auf, die im einzelnen folgendermaßen verschaltet sind.

Die integrierte Schaltung 10 weist einen Kollektoranschluß C, einen Basisanschluß B sowie einen Emitteranschluß E auf. Der Leistungstransistor 12 wird von den Transistoren T1, T2 und T3 gebildet, die in einer Darlington-Schaltung geschaltet sind. Die Transistoren T1, T2 und T3 sind als npn-Transistoren ausgestaltet.

Die Schaltungsanordnung 14 weist die Transistoren T4, T5 und T6 auf, wobei der Transistor T5 als pnp- oder npn- Transistor und die Transistoren T4 und T6 als npn- Transistor ausgebildet sind.

Der Basisanschluß B ist mit dem Kollektor des Transistors T4 verbunden. Der Emitter des Transistors T4 ist mit der Basis des Transistors T1 verbunden. Der Kollektor der Transistoren T1, T2 und T3 ist mit dem Kollektoranschluß C verbunden. Der Emitter des Transistors T1 ist mit der Basis der Transistoren T2 und T3 verbunden. Der Emitter des Transistors T3 ist mit dem Emitteranschluß E verbunden. Die Basis des Transistors T5 ist über einen Widerstand R3 mit dem Emitter des Transistors T5 verbunden. Der Widerstand R3 ist als temperaturabhängiger Widerstand mit einem positiven Temperaturkoeffizienten ausgebildet. Der Kollektor des Transistors T4 ist weiterhin mit dem Emitter des Transistors T5 im Falle eines pnp-Transistors, sonst mit dem Kollektor des Transistors T5 im Falle eines npn-Transistors (Fig. 1a) und über den Widerstand R2 mit dem Kollektor des Transistors T6 verbunden. Der Kollektor des Transistors T6 ist weiterhin mit der Basis des Transistors T4 verbunden. Der Kollektor des Transistors T5 ist im Falle des pnp-Transistors, sonst der Emitter des Transistors T5 im Falle des npn-Transistors, einerseits mit der Basis des Transistors T6 und andererseits über den Widerstand R4 mit dem Emitteranschluß E verbunden. Der Emitter des Transistors T6 ist ebenfalls mit dem Emitteranschluß E verbunden.

Die integrierte Schaltung 10 übt folgende Funktion aus:

Während des bestimmungsgemäßen Einsatzes der integrierten Schaltung 10 kann mittels des Leistungstransistors 12 zwischen dem Kollektoranschluß C und dem Emitteranschluß E eine Last geschaltet werden. Die Ansteuerung des Leistungstransistors 12 erfolgt über den zwischen dem Basisanschluß B und der Basis des Transistors T1 "längs" geschalteten Transistors T4. Über den Transistor T4 kann somit der Basisstrom I des Leistungstransistors 12 beeinflußt werden. Der Transistor T5 speist seinen Sperrstrom I_{CER} in den Widerstand R4 und in die Basis von T6 ein. Da Easis und Emitter von T5 über R3 niederohmig verbunden sind, ergibt sich ein Kurzschluß für kleine Ströme zwischen Basis und Emitter, so daß I_{CER} ∼ I_{CES} (I_{CES}-Mode). Daraus resultiert an der Basis des Transistors T6 eine Spannung, die jedoch zu klein ist um den Transistor T6 zu aktivieren.

Tritt nun eine Erwärmung der integrierten Schaltung 10, die insbesondere durch eine an dem Leistungstransistor 12 verursachte Verlustleistung hervorgerufen wird, auf, erhöht der Widerstand R3 aufgrund dessen positiven Temperaturkoeffizienten seinen Widerstandswert stark. Hierdurch geht der Transistor T5 in seinen I_{CEO}-Mode über, das heißt, die Basis des Transistors T5 verhält sich nahezu so, als ob sie offen wäre, so daß I_{CER} ∼ I_{CEO} ist. Aufgrund der Erwärmung der Schaltungsanordnung 14 erhöht sich der Widerstandswert des Widerstandes R3 mit einer Potenzfunktion, während der Sperrstrom des Transistors T5 exponentiell ansteigt. Die Basis-Emitter-Durchbruchspannung des Transistors T5 nimmt gleichzeitig mit <-2mV/K ab. Durch den sich einstellenden, wesentlich höheren, um ca. 2 Zehnerpotenzen steigenden, Sperrstrom des Transistors T5 ergibt sich eine höhere Basis-Emitter-Spannung U_{BE} des Transistors T6, so daß dieser aktiviert wird. Hierdurch wird die Basis des Transistors T4 angesteuert, so daß über den Transistor T4 der Basisstrom I des Leistungstransistors 12 beeinflußt wird. Somit wird klar, daß über die Höhe des sich einstellenden Sperrstromes des Transistors T5 Einfluß auf den Basisstrom I des Leistungstransistors 12 genommen werden kann.

Je nach Größe des sich einstellenden Sperrstromes wird der Basisstrom I mehr oder weniger abgeregelt, so daß eine kontinuierliche Reduktion der Verlustleistung des Leistungstransistors 12 möglich wird. Durch einen kontinuierlichen Anstieg des Sperrstromes des Transistors T5 infolge der eintretenden Erwärmung verringert sich in gleichem Maße der Basisstrom I des Leistungstransistors 12, so daß dieser kontinuierlich heruntergefahren wird. Durch die kontinuierliche Verringerung des Basisstromes des Leistungstransistors 12 wird vermieden, daß es zwischen dem Kollektoranschluß C und dem Emitteranschluß E zu unkontrollierten Spannungsüberhöhungen kommen kann. Insbesondere, wenn der Leistungstransistor 12 zum Ansteuern einer Zündspule in Kraftfahrzeugen eingesetzt wird, können somit verfrühte Zündvorgänge aufgrund einer unkontrollierten Spannungsüberhöhung vermieden werden.

Trotz eines abgeregelten Leistungstransistors 12 steht am Kollektor des Transistors T4 die Quellenspannung der Basisversorgung der integrierten Schaltung 10 an. Somit wird erreicht, daß trotz eines abgeregelten Leistungstransistors 12 die Schaltungsanordnung 14 und damit der als thermisches Sensorelement geschaltete Transistor T5 eine ausreichend große treibende Spannung zur Verfügung hat. Hierdurch wird eine Funktion der Schaltungsanordnung 14 unabhängig vom Schaltungszustand des Leistungstransistors 12 gewährleistet. Die Spannung U_{BE} zwischen dem Basisanschluß B und dem Emitteranschluß E der integrierten Schaltung steigt durch die Abregelung des Transistors T4 mit steigender Temperatur an, während die Spannung U_{B'E} zwischen dem Punkt B' und dem Emitteranschluß E mit steigender Temperatur abfällt.

Eine Beeinflussungsmöglichkeit ist durch die Wahl der Größe des Widerstandes R3 oder dessen positiven Temperaturkoeffizienten gegeben, so daß der Übergang des Transistors T5 von dem I_{CES}-Mode in den I_{CEO}-Mode und damit der sich ergebende Einsatzpunkt der thermischen Abregelung des Leistungstransistors 12 festlegbar ist. Insgesamt ergeben sich hierdurch die Möglichkeiten, die thermische Abregelung des Leistungstransistors 12 bei sehr hohen Temperaturen, die beispielsweise über 200 °C liegen können, durchzuführen.

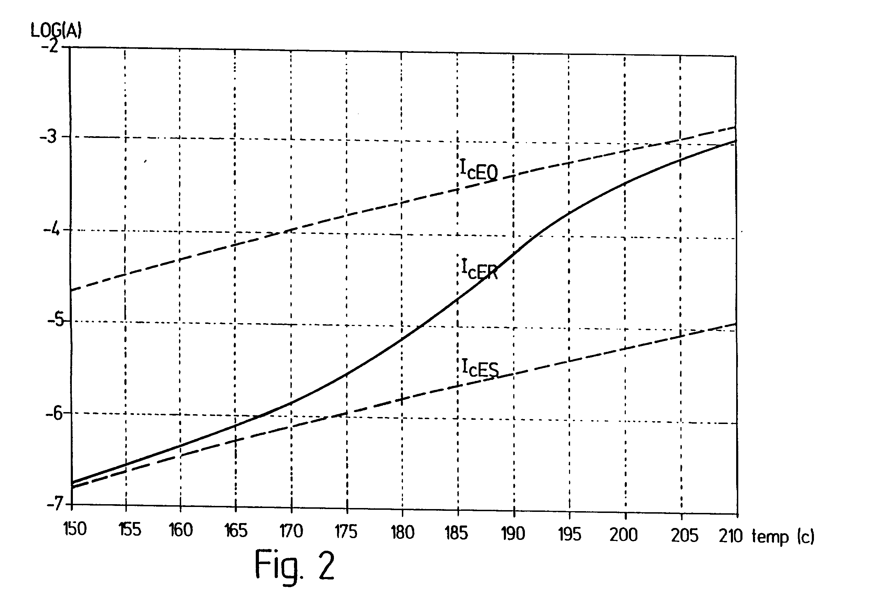

In der Figur 2 ist der Übergang des Sperrstromes I_{CER} vom I_{CES}-Mode in den I_{CEO}-Mode des Transistors T5 verdeutlicht. Der Sperrstrom I_{CER} ist hier logarithmisch über der Temperatur aufgetragen. Es wird deutlich, daß mit steigender Temperatur der wesentlich von dem Widerstand R3 beeinflußte, und hier mit I_{CER} bezeichnete Sperrstrom von dem I_{CES}-Mode in den I_{CEO}-Mode übergeht. Nach einem allmählichem Ansteigen des Sperrstromes I_{CER} bis zu Temperaturen bei ca. 155 °C geht dieser mit einer steiler werdenden Flanke bis zu Temperaturen von über 200 °C in den I_{CEO}-Mode über. Durch das Ansteigen der Flanke des Sperrstromes I_{CER} erfolgt ein entsprechendes Zusteuern des Transistors T4 und damit entsprechende Beeinflussung des Basisstromes I des Leistungstransistors 12.

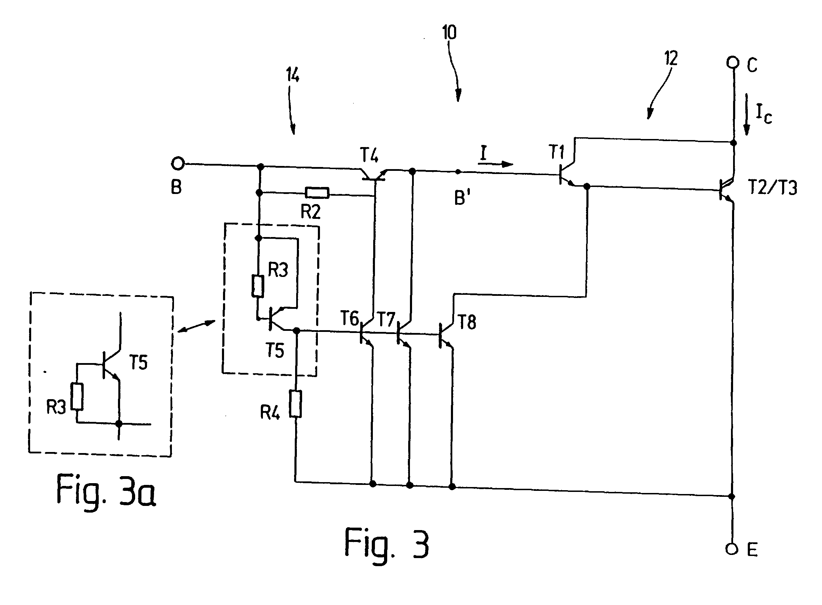

In der Figur 3 ist eine weitere integrierte Schaltung 10 gezeigt, bei der gleiche Teile wie in Figur 1 mit gleichen Bezugszeichen versehen und nicht nochmals erläutert sind. In der Schaltungsanordnung 14 sind hier zusätzlich die Transistoren T7 und T8 vorgesehen, die jeweils als npn-Transistor ausgebildet sind. Der Kollektor des Transistors T5 im Falle des pnp-Transistors, der Emitter des Transistors T5 im Falle des npn-Transistors (Fig. 3a), ist hier neben der Basis des Transistors T6 gleichzeitig mit der Basis des Transistors T7 und der Basis des Transistors T8 verbunden. Der Kollektor des Transistors T7 ist mit der Basis des Transistors T1 verbunden. Der Kollektor des Transistors T8 ist mit dem Emitter des Transistors T1 verbunden. Die Emitter der Transistoren T7 und T8 sind mit dem Emitteranschluß E verbunden.

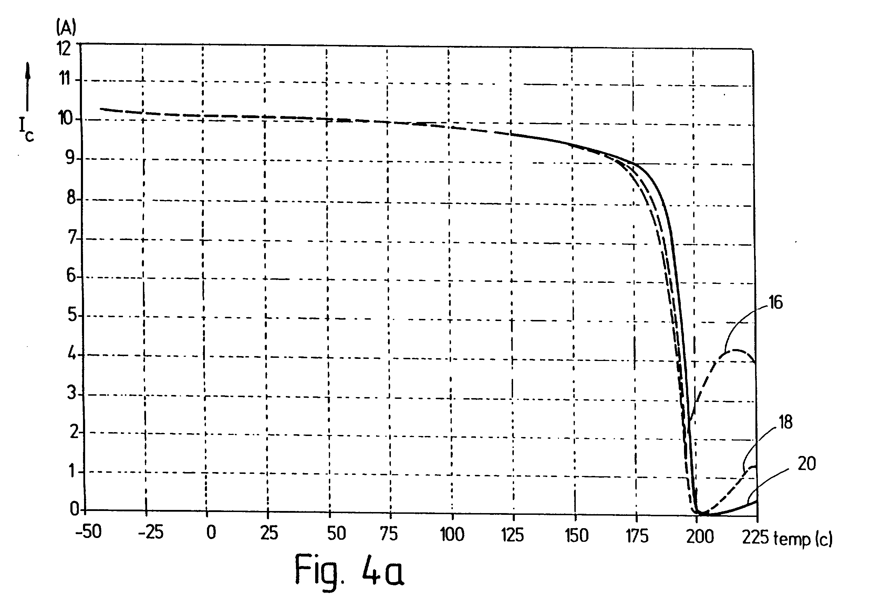

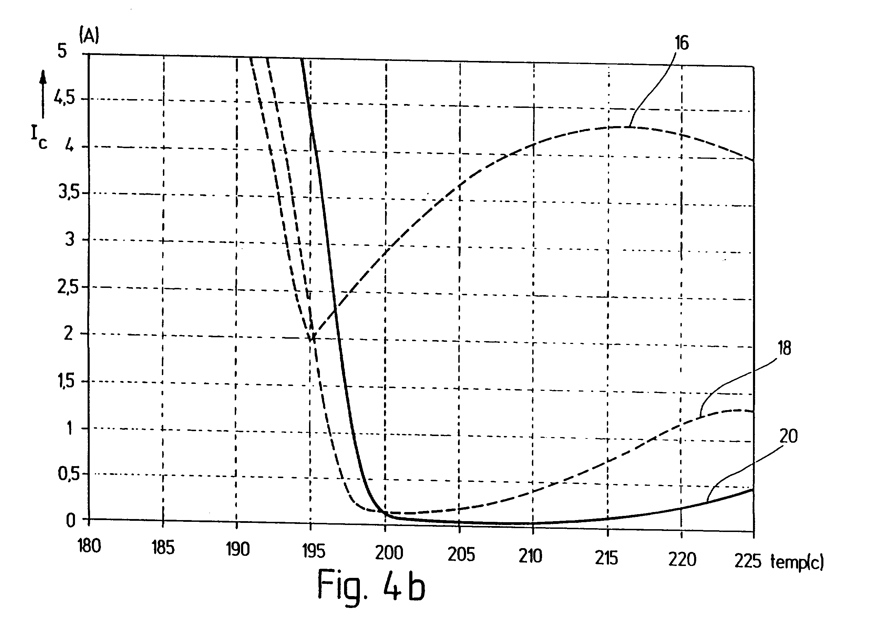

Die zusätzlichen Transistoren T7 und T8 werden ebenfalls durch den Sperrstrom des Transistors T5 angesteuert. Die Ansteuerung der Transistoren T7 und T8 erfolgt ebenfalls erst im Arbeitspunkt des Transistors T5, also, wenn dieser aufgrund steigender Temperaturen von dem I_{CES}-Mode in den I_{CEO}-Mode übergeht. Durch die in Emitterschaltung geschalteten Transistoren T7 und T8 wird erreicht, daß bei einem steigenden Sperrstrom des Transistors T5, der einem steigenden Basisstrom der Transistoren T7 und T8 entspricht, die Kollektor-Emitter-Spannung U_{CE} der Transistoren T7 und T8 ansteigt. Hierdurch wirken die Transistoren T7 und T8 als "thermische Ausräumer", die das Abregeln des Basisstromes I des Leistungstransistors 12 insbesondere bei hohen Temperaturen beeinflussen. Die sich unterschiedlich ergebenden Kennlinien des Kollektorstromes I_{C} der Gesamtschaltung sind in den Figuren 4a und 4b anhand von Simulationskurven dargestellt. Die Figur 4b zeigt eine Ausschnittsvergrößerung des Kurvenverlaufs gemäß der Figur 4a im Bereich der höheren Temperaturen.

Insgesamt sind drei Kurvenverläufe dargestellt, die den Verlauf des Kollektorstromes I_{C} in Abhängigkeit der Temperatur darstellen. Eine erste Kurve 16 gibt den Verlauf entsprechend der in Figur 1 gezeigten Schaltungsanordnung wieder. Mit steigender Temperatur sinkt der Kollektorstrom I_{C}, beispielsweise von einem Wert von 10 A auf einen Wert von ca. 2 A bei ca. 195 °C ab, um dann durch das sogenannte "thermische Weglaufen" des Leistungstransistors 12 mit steigender Temperatur wieder anzusteigen. Eine zweite Kurve 18 verdeutlicht den Verlauf des Kollektorstromes I_{C} bei zusätzlich zugeschaltetem Transistor T7. Neben der deutlich größeren Absenkung des Kollektorstromes I_{C} auf Werte von unter 500 mA wird der Beginn des "thermischen Weglaufens" des Leistungstransistors 12 zu einer höheren Temperatur von ca. 200 °C verschoben. Gleichzeitig fällt die Erhöhung des Kollektorstromes I_{C} bei den höheren Temperaturen deutlich geringer aus. Eine dritte Kurve 20 zeigt den Verlauf des Kollektorstromes I_{C} bei gleichzeitiger Ansteuerung der Transistoren T6, T7 und T8 durch den Sperrstrom des Transistors T5. Es tritt eine nochmalige Verschiebung des Beginns des "thermischen Weglaufens" des Leistungstransistors 12 zu höheren Temperaturen von ca. 210 °C ein, wobei der Temperaturanstieg nochmals deutlich begrenzt ist. Somit kann eine Abregelung des Kollektorstromes I_{C} des Leistungstransistors 12 auf Temperaturen von weit über 200 °C verschoben werden.

## Patentansprüche

1. Integrierte Schaltung mit einem Leistungstransistor (T1, T2, T3) und mit einer temperaturabhängig arbeitenden, mit dem Leistungstransistor thermisch gekoppelten Schaltungsanordnung (14), wobei die integrierte Schaltung einen Basisanschluß (B), einen Emitteranschluß (E) und einen Kollektoranschluß (C) aufweist, dadurch gekennzeichnet, daß die Schaltungsanordnung (14) einen ersten pnp- oder npn-Transistor (T5) aufweist, dessen Basis-Emitterstrecke mit einem temperaturabhängigen Widerstand (R3) mit positivem Temperaturkoeffizienten beschaltet ist und dessen sich temperaturabhängig ändernder Sperrstrom eine Abregelung des Basisstromes (I) des Leistungstransistors (T1, T2, T3) auslöst.

2. Integrierte Schaltung nach Anspruch 1, dadurch gekennzeichnet, daß ein zweiter Transistor (T4) vorgesehen ist, dessen Kollektor mit dem Basisanschluß (B) der integrierten Schaltung (10) und dessen Emitter mit der Basis (B') des Leistungstransistors (T1, T2, T3) verbunden ist, und über den der Basisstrom (I) des Leistungsstransistors (T1, T2, T3) fließt.

3. Integrierte Schaltung nach Anspruch 2, dadurch gekennzeichnet, daß der zweite Transistor (T4) über einen dritten Transistor (T6) ansteuerbar ist, dessen Basis mit dem Kollektor -bei pnp- beziehungsweise dem Emitter -bei npn- des ersten Transistors (T5) verbunden ist.

4. Integrierte Schaltung nach Anspruch 3, dadurch gekennzeichnet, daß der Kollektor -bei pnp- beziehungsweise der Emitter -bei npn- des Transistors (T5) über einen zweiten Widerstand (R4) mit dem Emitteranschluß (E) der integrierten Schaltung (10) verbunden ist.

5. Integrierte Schaltung nach einem der vorhergehenden Ansprüche, dadurch gekennzeichnet, daß der Kollektor -bei pnp- beziehungsweise der Emitter -bei npn- des ersten Transistors (T5) mit der Basis eines vierten Transistors (T7) verbunden ist, dessen Kollektor mit der Basis des Leistungstransistors (T1, T2, T3) und dessen Emitter mit dem Emitteranschluß (E) verbunden ist.

6. Integrierte Schaltung nach einem der vorhergehenden Ansprüche, dadurch gekennzeichnet, daß der Leistungstransistor eine Darlingtonschaltung mit einem ersten Teiltransistor (T1) und einem zweiten Teiltransistor (T2, T3) aufweist und daß der Kollektor -bei pnp- beziehungsweise der Emitter -bei npn- des ersten Transistors (T5) mit der Basis eines fünften Transistors (T8) verbunden ist, dessen Kollektor mit dem Emitter des ersten Teiltransistors (T1) und dessen Emitter mit dem Emitteranschluß (E) verbunden ist.

## Claims

1. Integrated circuit having a power transistor (T1, T2, T3) and having a circuit arrangement (14) which operates in a temperature-dependent manner and is thermally coupled to the power transistor, the integrated circuit having a base terminal (B), an emitter terminal (E) and a collector terminal (C), characterized in that the circuit arrangement (14) has a first pnp or npn transistor (T5), whose base-emitter junction is connected to a thermistor (R3) with positive temperature coefficient and whose reverse current, which changes in a temperature-dependent manner, triggers limiting of the base current (I) of the power transistor (T1, T2, T3).

2. Integrated circuit according to Claim 1, characterized in that a second transistor (T4) is provided, whose collector is connected to the base terminal (B) of the integrated circuit (10) and whose emitter is connected to the base (B') of the power transistor (T1, T2, T3), and via which the base current (I) of the power transistor (T1, T2, T3) flows.

3. Integrated circuit according to Claim 2, characterized in that the second transistor (T4) can be driven via a third transistor (T6), whose base is connected to the collector - in the case of pnp - or to the emitter - in the case of npn - of the first transistor (T5).

4. Integrated circuit according to Claim 3, characterized in that the collector - in the case of pnp - or the emitter - in the case of npn - of the transistor (T5) is connected to the emitter terminal (E) of the integrated circuit (10), via a second resistor (R4).

5. Integrated circuit according to one of the preceding claims, characterized in that the collector - in the case of pnp - or the emitter - in the case of npn - of the first transistor (T5) is connected to the base of a fourth transistor (T7), whose collector is connected to the base of the power transistor (T1, T2, T3) and whose emitter is connected to the emitter terminal (E).

6. Integrated circuit according to one of the preceding claims, characterized in that the power transistor has a Darlington circuit with a first sub-transistor (T1) and a second sub-transistor (T2, T3), and in that the collector - in the case of pnp - or the emitter - in the case of npn - of the first transistor (T5) is connected to the base of a fifth transistor (T8), whose collector is connected to the emitter of the first sub-transistor (T1) and whose emitter is connected to the emitter terminal (E).

## Revendications

1. Circuit intégré comportant un transistor de puissance (T1, T2, T3) et un circuit (14) couplé thermiquement au transistor de puissance et travaillant en fonction de la température, le circuit intégré ayant une borne de base (B), une borne d'émetteur (E) et une borne de collecteur (C),
caractérisé en ce que
le circuit (14) comprend un premier transistor pnp ou npn dont le chemin base-émetteur comporte une résistance (R3) dépendant de la température, à coefficient de température positif, et dont le courant de blocage, variable en fonction de la température, déclenche une régulation du courant de base (I) du transistor de puissance (T1, T2, T3).

2. Circuit intégré selon la revendication 1,
caractérisé en ce qu'
un second transistor (T4) dont le collecteur est relié à la borne de base (B) du circuit intégré (10) et dont l'émetteur est relié à la base (B') du transistor de puissance (T1, T2, T3), est traversé par les courants de base (I) du transistor de puissance (T1, T2, T3).

3. Circuit intégré selon la revendication 2,
caractérisé en ce que
le second transistor (T4) est commandé par un troisième transistor (T6) dont la base est reliée au collecteur (dans le cas d'un transistor de type pnp) ou à l'émetteur (dans le cas d'un transistor npn) du premier transistor (T5).

4. Circuit intégré selon la revendication 3,
caractérisé en ce que
le collecteur (dans un transistor de type pnp) ou l'émetteur (dans le cas d'un transistor npn) du transistor (T5) est relié par une seconde résistance (R4) à la borne d'émetteur (E) du circuit intégré (10).

5. Circuit intégré selon l'une des revendications précédentes,
caractérisé en ce que
le collecteur (dans le cas d'un transistor de type pnp) ou l'émetteur (dans le cas d'un transistor de type npn) du premier transistor (T5) est relié à la base d'un quatrième transistor (T7) dont le collecteur est relié à la base du transistor de puissance (T1, T2, T3) et dont l'émetteur est relié à la borne d'émetteur (E).

6. Circuit intégré selon l'une des revendications précédentes,
caractérisé en ce que
le transistor de puissance comprend un circuit Darlington avec un premier transistor partiel (T1) et un second transistor partiel (T2, T3) et le collecteur (dans le cas d'un transistor de type pnp) ou l'émetteur (dans le cas d'un transistor de type npn) du premier transistor (T5) est relié à la base d'un cinquième transistor (T8) dont le collecteur est relié à l'émetteur du premier transistor partiel (T1) et dont l'émetteur est relié à la borne d'émetteur (E).
